# FASCICULE DE BREVET EUROPEEN

(11) **EP 0 561 721 B1**
(45) Date de publication et mention de la délivrance du brevet: **19.05.1999**
(21) Numéro de dépôt: 93420121.1
(22) Date de dépôt: 17.03.1993
(51) Int. Cl.: H01L 29/74, H01L 29/86, H01L 29/08

(54) **Interrupteur de tension alternative**
Wechselspannungsschalter
Switch for alternating voltages

(30) Priorité: 20.03.1992 FR 9203763
(43) Date de publication de la demande: 22.09.1993
(73) Titulaire: STMicroelectronics S.A., 94250 Gentilly (FR)
(72) Inventeur: Pezzani, Robert, F-37210 Vouvray (FR)
(74) Mandataire: de Beaumont, Michel

(56) Documents cités:
- FR-A- 2 279 224
- FR-A- 2 433 845
- PATENT ABSTRACTS OF JAPAN vol. 5, no. 179 (E-82)(851) 17 Novembre 1981 & JP-A-56 104 467 ( NIPPON DENSHIN DENWA KOSHA ) 30 Août 1981
- PATENT ABSTRACTS OF JAPAN vol. 10, no. 337 (E-454)(2393) 14 Novembre 1986 & JP-A-61 140 174 ( HITACHI LTD ) 27 Juin 1986

## Description

La présente invention concerne le domaine des interrupteurs de courant alternatif moyenne ou forte puissance. Plus particulièrement, la présente invention vise à la réalisation sous forme monolithique d'un interrupteur de tension alternative susceptible d'être mis en conduction seulement au cours d'une alternance de polarité déterminée et laissant passer automatiquement l'alternance suivante.

L'interrupteur de courant alternatif le plus répandu actuellement est le triac dont la mise en conduction est déclenchée par un signal appliqué entre sa gâchette et l'une de ses bornes principales. Cet interrupteur se rebloque à chaque passage à zéro du courant et il convient de le commander à chaque alternance.

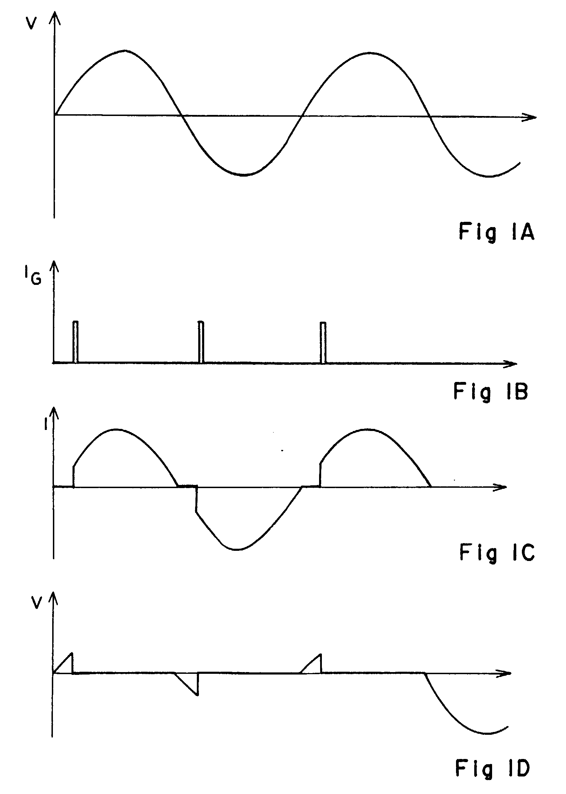

Le fonctionnement d'un triac est illustré schématiquement en relation avec les figures 1A à 1D où la figure 1A représente l'allure de la tension du secteur, la figure 1B des impulsions de commande I_{g} fournies à la gâchette du triac, la figure 1C le courant traversant le triac, et la figure 1D la tension aux bornes du triac. Pour simplifier la représentation, on a supposé dans cet exemple qu'il n'y avait pas de déphasage entre la tension et le courant.

On voit que si une impulsion de commande I_{g} est appliquée pendant une alternance positive ou négative de la tension du réseau, le triac entre en conduction puis qu'il se rebloque à chaque passage à zéro du courant pour rester bloqué si aucune impulsion de commande ne lui est appliquée.

Un tel composant s'avère efficace pour faire de la régulation de puissance à commande en contrôle de phase. On peut toutefois noter un certain nombre d'inconvénients liés à la structure même du triac et à certaines applications.
- La structure géométrique d'un triac est complexe, en particulier au niveau des zones correspondant à la région de gâchette, ce qui rend le triac difficile à fabriquer.
- Cette structure géométrique complexe limite les performances du triac qui a notamment généralement une sensibilité de commande médiocre et on préfère dans certaines applications où l'on recherche une grande sensibilité lui substituer un thyristor associé à un pont redresseur, c'est-à-dire que l'on renonce à utiliser un composant monolithique.
- Dans certaines applications, par exemple lorsque l'interrupteur est en série avec un transformateur, il est préférable après une phase de repos de réamorcer le triac lors d'une alternance de polarité opposée à celle de la dernière phase de conduction pour éviter des inconvénients de sur-appel de courant produits par des phénomènes de magnétisation/démagnétisation. Ceci oblige à associer au triac des circuits de commande complexes gardant en mémoire la polarité de la dernière alternance de conduction et autorisant un déclenchement seulement lors d'une alternance de polarité opposée.

Un autre type de composant semiconducteur monolitique est décrit dans FR-A-2433845.

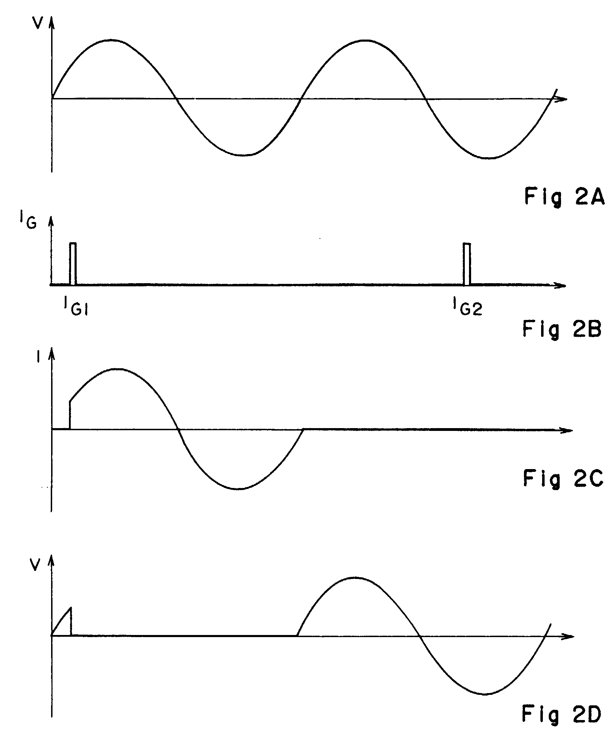

Pour pallier ce dernier inconvénient, un objet de la présente invention est de réaliser un composant monolithique présentant les caractéristiques illustrées en figures 2A à 2D où la figure 2A, comme la figure 1A, représente la tension secteur, la figure 2B représente l'impulsion de commande I_{g} appliquée sur la gâchette du composant, et les figures 2C et 2D représentent respectivement le courant I à travers le composant et la tension V à ses bornes. Le but recherché est qu'une impulsion de commande Ig1 survenant pendant une alternance de polarité donnée, par exemple positive, de la tension du secteur produise la mise en conduction de l'interrupteur pendant la fin de l'alternance en cours et pendant toute l'alternance suivante tandis qu'une impulsion de commande Ig2 survenant pendant une alternance de polarité opposée de la tension du secteur n'ait aucun effet sur la mise en conduction de l'interrupteur.

Un autre objet de la présente invention est de prévoir un tel composant monolithique de structure géométrique simple.

Un autre objet de la présente invention est de prévoir un tel composant monolithique pouvant présenter des caractéristiques souhaitées, par exemple de sensibilité de commande, de tension de claquage en direct et en inverse, et de tenue aux déclenchements parasites en dI/dT et dV/dT.

Pour atteindre ces objets, la présente invention telle que revendiquée dans la revendication 1 prévoit un interrupteur de tension alternative réalisé sous forme de composant monolithique à partir d'un substrat semiconducteur faiblement dopé d'un premier type de conductivité, comprenant à partir de sa surface supérieure des première et deuxième régions séparées du deuxième type de conductivité. Une partie de la première région est solidaire d'une électrode de gâchette et comprend une diffusion d'une troisième région du premier type de conductivité. La troisième région et une partie de la première région sont recouvertes d'une métallisation. La face inférieure du composant comprend en-dessous de la troisième région une quatrième région du deuxième type de conductivité et en-dessous du reste de la deuxième région une cinquième région du premier type de conductivité. La deuxième région comprend des zones espacées du premier type de conductivité et la face inférieure du substrat comprend, en face de la deuxième région, des sixièmes et septièmes régions espacées et alternées des premier et deuxième type de conductivité, cette face inférieure étant recouverte d'une métallisation de même que la surface de la deuxième région et desdites zones espacées.

Selon un mode de réalisation de la présente invention, les septièmes régions sont intercalées entre les projections desdites zones espacées.

Selon un mode de réalisation de la présente invention, une huitième région du premier type de conductivité à niveau de dopage élevé devant celui du substrat est interposée entre les première et deuxième régions.

Selon un mode de réalisation de la présente invention, une neuvième région du premier type de conductivité à niveau de dopage élevé devant celui du substrat est disposée à la périphérie de la face supérieure du substrat.

Ces objets, caractéristiques et avantages ainsi que d'autres de la présente invention seront exposés en détail dans la description suivante de modes de réalisation particuliers faite en relation avec les figures jointes parmi lesquelles :
les figures 1A à 1D sont des chronogrammes illustrant le fonctionnement d'un triac ;
les figures 2A à 2D sont des chronogrammes illustrant le fonctionnement souhaité d'un composant selon la présente invention;
la figure 3 représente un schéma équivalent d'un composant selon la présente invention ;
la figure 4 représente une vue en coupe schématique, non à l'échelle, d'un composant selon la présente invention ; et
la figure 5 représente un schéma équivalent plus détaillé d'un composant selon la présente invention.

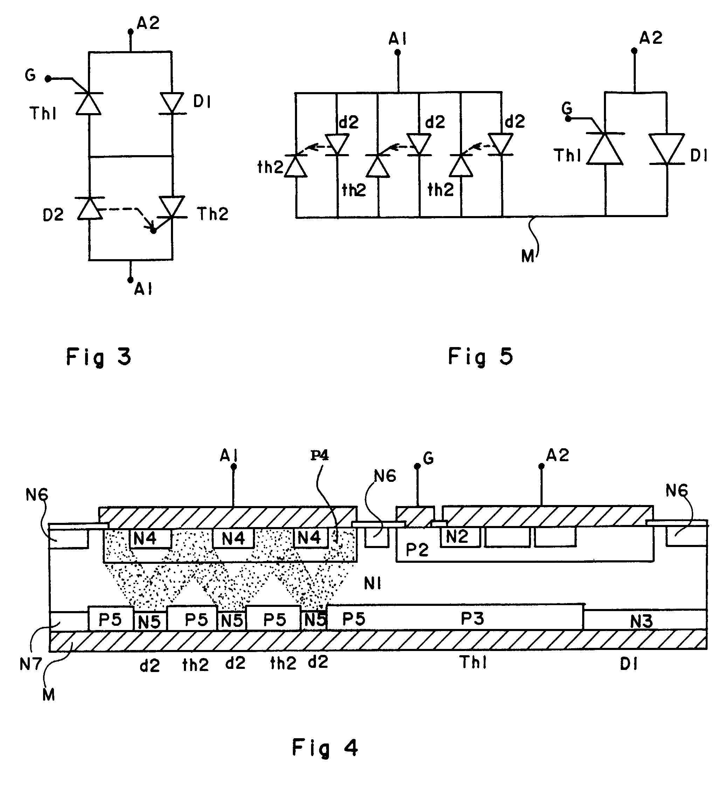

Comme le représente la figure 3, la présente invention vise à réaliser un composant semiconducteur monolithique correspondant à un premier thyristor Th1 classique muni d'une électrode de gâchette G, en anti-parallèle avec une diode D1, cet ensemble étant en série avec un deuxième thyristor Th2 en anti-parallèle avec une diode D2, le composant étant connecté entre des bornes A2 et A1. Ainsi, ce composant comprend deux bornes principales A2 et A1 et une borne de gâchette G. Le thyristor Th2 est tel que sa conduction est provoquée de façon automatique lors d'une alternance quand la diode D2 a été conductrice pendant l'alternance précédente. Ainsi, si la borne A1 est positive par rapport à la borne A2, le courant est susceptible de passer entre les bornes A1 et A2 par la diode D2 et le thyristor Th1 à condition que le transistor Th1 ait reçu une impulsion de commande de gâchette. Quand la borne A2 est positive par rapport à la borne A1, le courant passe par la diode D1 et le transistor Th2 à condition que la diode D2 ait été conductrice lors de l'alternance précédente.

La figure 4 est une vue en coupe schématique d'un exemple de réalisation d'un composant selon la présente invention.

On reconnaît dans la partie droite de la figure 4 la structure classique d'un thyristor à diode anti-parallèle. La partie gauche de la figure correspond aux composants D2, Th2 comme cela sera exposé ci-après.

On va d'abord décrire la partie droite de la structure du composant. Le composant est constitué à partir d'un substrat N1 de type N dans la surface supérieure duquel est diffusée une couche P2 de type P constituant la couche de gâchette du thyristor et la couche d'anode de la diode D1. Une région N2 de type N est diffusée dans la région P2 pour former la cathode du thyristor. On a représenté de façon classique des zones de la région P2 remontant à travers la couche N2 jusqu'à la surface du composant et constituant ce que l'on appelle classiquement des courts-circuits d'émetteur. De façon connue, ces courts-circuits d'émetteur sont de très petites dimensions et ont par exemple un diamètre d'une cinquantaine de micromètres. La partie droite de la région P2 ne comprend pas de région N2 diffusée et correspond à l'anode de la diode D1. Sous la partie de thyristor de la région P2 (celle où est diffusée la région N2), est formée à partir de la face inférieure du composant une région P3 de type P correspondant à l'anode du thryristor Th1. Sous la partie de diode de la région P2 (celle où aucune diffusion de type N n'est effectuée, autre que la zone de gâchette), est formée à partir de la face inférieure du substrat une région N3 de type N correspondant à la cathode de la diode D1. De préférence, la région P3 déborde vers l'extérieur par rapport à la projection de la région N2 pour éviter toute interférence entre la conduction de la diode D1 et celle du thyristor Th1. Cette structure ne sera pas décrite plus en détail car elle correspond à la structure classique d'un thyristor à diode anti-parallèle. Une métallisation A2 est déposée sur les couches N2 et P2 et la face inférieure est métallisée (M) pour, notamment, contacter les régions P3 et N3.

Dans la partie gauche de la figure 4, on a représenté une structure constituée de façon imbriquée de thyristors et de diodes verticales.

Dans la surface supérieure du substrat N1 est formée une région P4, réalisée en même temps que la région P2. Dans cette région P4 sont formées de façon nettement espacée des régions N4 de type N, réalisée en même temps que la région N2. A partir de la face inférieure du substrat sont formées de façon alternée des régions P5 et N5. De préférence, bien que cela ne soit pas obligatoire, les régions N5 se trouvent en projection sous les régions N4. Une métallisation A1 est formée sur l'ensemble de la région P4 et des régions incorporées N4. Les régions P5 et N5 sont solidaires de la métallisation M de face inférieure. Ainsi, entre les métallisations A1 et M on trouve des thyristors élémentaires th2 constitués des couches N4-P4-N1-P5 dont l'électrode A1 forme la cathode et dont la métallisation M forme l'anode. On trouve également des diodes élémentaires d2 constituées des couches P4-N1-N5 dont l'électrode A1 forme l'anode et la métallisation M la cathode.

Quand l'électrode A1 est positive par rapport à l'électrode A2 et que le thyristor Th1 est commandé à l'état passant, un courant circule dans les diodes élémentaires d2, établissant des zones de conduction figurées en pointillés dans la partie gauche de la figure.

Au moment où la tension s'inverse aux bornes du composant, le courant va s'annuler. Cependant les charges injectées durant la conduction précédente des diodes d2 au niveau des thyristors élémentaires th2, ne disparaissent pas instantanément, en particulier celles en excès dans la couche N1 faiblement dopée. Ainsi, les petits thyristors th2 qui se trouvent polarisés en direct voient encore des charges dans leur couche N1. Ces charges jouent le rôle d'un courant de gâchette et provoquent l'amorçage naturel des transistors th2. La conduction s'établit donc de A2 vers A1 à travers la diode D1 et les thyristors th2 sans intervention extérieure. Cette conduction se poursuit jusqu'à ce que le courant s'annule entre les bornes A1 et A2. Par contre, le thyristor Th1 qui, de façon classique, est nettement séparé dans sa structure de la diode D1 ne s'amorce pas de façon automatique puisque la couche N1 ne contient pas de porteurs sous la région de cathode de ce thyristor.

La figure 5 représente un schéma équivalent du circuit de la figure 4, de même type que celui de la figure 3. Dans cette figure, on a représenté les diodes d2 et les thyristors th2 de façon élémentaire.

La présente invention a été décrite de façon extrêmement schématique. L'homme de l'art saura adapter les niveaux de dopage des diverses couches à ses besoins spécifiques et diverses variantes de structure lui apparaîtront. Par exemple, on pourra prévoir, comme cela est représenté en figure 4 des régions N6 de type N entre les régions P2 et P4 et à la périphérie supérieure de composant de même qu'une région N7 à la périphérie inférieure de celui-ci.

En ce qui concerne la réalisation du thyristor Th1 et de la diode D1, tous les perfectionnements habituels connus dans la technique pourront être utilisés. Par exemple, le thyristor pourra être du type à amplification de gâchette.

Pour que le composant selon la présente invention ait des caractéristiques symétriques de passage de courant dans les deux sens de polarisation, il convient d'harmoniser les surfaces de silicium. Si on appelle S1 la surface de la région N2 (en oubliant les courts-circuits d'émetteur dont la surface est négligeable), et S2 la surface de la région P2 correspondant à la diode D1 (cette surface S2 étant généralement de l'ordre de la moitié de la surface S1), la surface d'ensemble des régions N4 sera choisie sensiblement égale à S1, les affleurements répartis de la région P4 ayant une surface sensiblement égale à la surface S2.

Diverses formes géométriques pourront être adoptées pour le composant selon l'invention. Par exemple, les régions N4 pourront avoir, en vue de dessus, la forme de bandes intercalées avec des bandes de la région P4.

## Revendications

1. Interrupteur de tension alternative réalisé sous forme de composant monolithique à partir d'un substrat semiconducteur (N1) faiblement dopé d'un premier type de conductivité, comprenant à partir de sa surface supérieure des première (P2) et deuxième (P4) régions séparées du deuxième type de conductivité, une partie de la première région étant solidaire d'une d'électrode de gâchette (G) et comprenant une diffusion d'une troisième région du premier type de conductivité (N2), ladite troisième région et une partie de la première région étant recouvertes d'une métallisation (A2), la face inférieure du composant comprenant en-dessous de la troisième région une quatrième région (P3) du deuxième type de conductivité et en-dessous du reste de la première région une cinquième région (N3) du premier type de conductivité, la deuxième région (P4) comprenant des zones espacées (N4) du premier type de conductivité, et la face inférieure du substrat comprenant, en face de la deuxième région, des sixièmes (N5) et septièmes (P5) régions espacées et alternées des premier et deuxième type de conductivité, cette face inférieure étant recouverte d'une métallisation (M) de même que la surface de la deuxième région (P4) et desdites zones espacées (N4).

2. Interrupteur selon la revendication 1, caractérisé en ce que les septièmes régions (P5) sont intercalées entre les projections desdites zones espacées (N4).

3. Interrupteur selon la revendication 1, caractérisé en ce qu'une huitième région (N6) du premier type de conductivité à niveau de dopage élevé devant celui du substrat est interposée entre les première et deuxième régions (P2 et P4).

4. Interrupteur selon la revendication 1, caractérisé en ce qu'une neuvième région (N6) du premier type de conductivité à niveau de dopage élevé devant celui du substrat est disposée à la périphérie de la face supérieure du substrat.

## Claims

1. An a.c. switch realized in the form of a monolithic component from a low doped semiconductor substrate (N1), of a first conductivity type, including, from its upper surface, first (P2) and second ( P4) separate regions of the second conductivity type, a portion of said first region being part of a gate electrode (G), and including a diffusion of a third region (N2) of the first conductivity type, said third region and a portion of said first region being coated with a metallization (A2), the lower surface of the component including, beneath said third region, a fourth region (P3) of the second conductivity type, and beneath the rest of said first region, a fifth region (N3) of the first conductivity type, said second region including separated areas (N4) of the first conductivity type, the lower surface of said substrate including, in front of said second region, sixth (N5) and seventh ( P5) separated and alternate regions of the first and second conductivity type, said lower surface being coated with a metallization (M) as well as the surface of said second region (P4) and said separated areas (N4).

2. An a.c. switch according to claim 1, characterized in that the seventh regions (P5) are interposed between the projections of said separated areas (N4).

3. An a.c. switch according to claim 1, characterized in that an eighth region (N6) of the first conductivity type having a high doping level with respect to that of the substrate is interposed between said first (P2) and second (P4) regions.

4. An a.c. switch according to claim 1, characterized in that a ninth region (N6) of the first conductivity type having a high doping level as compared to that of the substrate is disposed at the periphery of the upper surface of said substrate.

## Patentansprüche

1. Wechselspannungsschalter in Ausführung in Form eines monolithischen Bauteils auf der Grundlage eines schwach dotierten Halbleitersubstrats (N1) von einem ersten Leitfähigkeitstyp, das ausgehend von seiner Oberseite getrennte erste (P2) und zweite (P4) Bereiche vom zweiten Leitfähigkeitstyp aufweist, wobei ein Teil des ersten Bereichs fest mit einer Gate-Elektrode (G) verbunden ist und eine Diffusion eines dritten Bereichs (N2) vom ersten Leitfähigkeitstyp umfaßt, wobei der genannte dritte Bereich und ein Teil des ersten Bereichs mit einer Metallisierung (A2) überzogen sind, wobei die Unterseite des Bauteils unterhalb dem dritten Bereich einen vierten Bereich (P3) vom zweiten Leitfähigkeitstyp und unterhalb dem übrigen Teil des ersten Bereichs einen fünften Bereich (N3) vom ersten Leitfähigkeitstyp aufweist, wobei der zweite Bereich (P4) voneinander beabstandete Zonen (N4) vom ersten Leitfähigkeitstyp aufweist und die Unterseite des Substrats gegenüber dem zweiten Bereich voneinander beabstandete und miteinander abwechselnd angeordnete sechste (P5) bzv. siebente (N5) Bereiche vom ersten bzw. vom zweiten Leitfähigkeitstyp aufweist, und wobei diese Unterseite mit einer Metallisierung (M) überzogen ist, ebenso wie die Oberfläche des zweiten Bereichs (P4) und der genannten voneinander beabstandeten Zonen (N4).

2. Schalter nach Anspruch 1, dadurch gekennzeichnet, daß die siebenten Bereiche (P5) zwischen den Projektionen der von einander beabstandeten Zonen (N4) mit diesen verschachtelt angeordnet sind.

3. Schalter nach Anspruch 1, dadurch gekennzeichnet, daß zwischen den ersten und zweiten Bereichen (P2 und P4) ein achter Bereich (N6) vom ersten Leitfähigkeitstyp und von höherem Dotierungsgrad als der des Substrats angeordnet ist.

4. Schalter nach Anspruch 1, dadurch gekennzeichnet, daß am Umfang der Oberseite des Substrats ein neunter Bereich (N6) vom ersten Leitfähigkeitstyp und von höherem Dotierungsgrad als der des Substrats angeordnet ist.
